# EUROPEAN PATENT APPLICATION

(11) **EP 4 387 422 A1**
(43) Date of publication of application: **19.06.2024**
(21) Application number: 23188642.5
(22) Date of filing: 31.07.2023
(51) Int. Cl.: H10K 59/122, H10K 59/32, H10K 59/80

(54) **ORGANIC LIGHT EMITTING DIODE DISPLAY DEVICE AND METHOD OF FABRICATING THE SAME**

(30) Priority: 14.12.2022 KR 20220174808
(71) Applicant: LG Display Co., Ltd., Seoul 07336 (KR)
(72) Inventor: KIM, Ho-Jin, 10845 Paju-si, Gyeonggi-do (KR); PARK, Ji-Yeon, 10845 Paju-si, Gyeonggi-do (KR)
(74) Representative: Viering, Jentschura & Partner mbB Patent- und Rechtsanwälte

(57) **Abstract**

An organic light emitting diode display device (100) includes a substrate (140) having first and second subpixels; an interlayer insulating layer (142) on the substrate (140) and having a trench (T) between the first and second subpixels; a first electrode (144) in each of the first and second subpixels on the interlayer insulating layer (142); a bank layer (146) covering an edge portion of the first electrode (144) and exposing a central portion of the first electrode (144); an emitting layer (148, 150, 152) and a second electrode (154) sequentially disposed on the bank layer (146) and the first electrode (144) exposed through the bank layer (146); and a passivation layer (156) on the second electrode (154) and wrapping the emitting layer (148, 150, 152) and the second electrode (154).

## Description

### CROSS-REFERENCE TO RELATED APPLICATION

The present application claims the priority of Korean Patent Application No. 10-2022-0174808 filed on December 14, 2022.

### BACKGROUND

### Field of the Disclosure

The present disclosure relates to an organic light emitting diode display device, and more particularly, to an organic light emitting diode display device including first and second stacks, a charge generating layer and a passivation layer surrounding a side surface of a second electrode and a method of driving the organic light emitting diode display device.

### Description of the Background

Recently, with the advent of an information-oriented society and as the interest in information displays for processing and displaying a massive amount of information and the demand for portable information media have increased, a display field has rapidly advanced. Thus, various light and thin flat panel display devices have been developed and highlighted.

Among the various flat panel display devices, an organic light emitting diode (OLED) display device is an emissive type device and does not include a backlight unit used in a non-emissive type device such as a liquid crystal display (LCD) device. As a result, the OLED display device has a light weight and a thin profile and has advantages in a viewing angle, a contrast ratio and a power consumption to be applied to various fields.

A head mounted display (HMD) including an organic light emitting display device has been recently developed. The HMD is a glass type monitor for a virtual reality (VR) or an augmented reality (AR) which is worn as a shape of a glass or a helmet such that a focus is formed at a point having a short distance from a user's eye.

The OLED display device having a small size and a high resolution applied to the HMD may be formed through a semiconductor process based on a wafer. In the semiconductor process, an anode is formed on an insulating layer covering a thin film transistor on the wafer. A current may flow through an emitting layer on the anode to cause a lateral leakage current.

Further, since the emitting layer may not be uniformly formed at an edge portion of the anode due to a step difference between the anode and the insulating layer, at least two of the anode, a charge generating layer and a cathode may be electrically shorted.

### SUMMARY

Accordingly, the present disclosure is directed to an organic light emitting diode display device and a method of fabricating the same, which among others substantially obviate one or more of the problems due to limitations and disadvantages described above.

More specifically, the present disclosure is to provide an organic light emitting display device where a lateral leakage current is prevented by dividing first and second stacks, a charge generating layer and a second electrode into each subpixel due to a trench having a relatively great width between subpixels and a method of fabricating the organic light emitting diode display device.

In addition, the present disclosure is to provide an organic light emitting diode display device where penetration of moisture and oxygen through a step corresponding line of an encapsulating layer is prevented and a reliability is improved by forming a passivation layer surrounding a side surface of first and second stacks, a charge generating layer and a second electrode divided into each subpixel and a method of fabricating the organic light emitting diode display device.

Additional features and advantages of the disclosure will be set forth in the description which follows, and in part will be apparent from the description, or may be learned by practice of the disclosure. These and other advantages of the disclosure will be realized and attained by the structure particularly pointed out in the written description hereof as well as the appended drawings.

In an aspect of the present disclosure, as embodied and broadly described herein, an organic light emitting diode display device includes a substrate having first and second subpixels; an interlayer insulating layer on the substrate and having a trench between the first and second subpixels; a first electrode in each of the first and second subpixels on the interlayer insulating layer; a bank layer covering an edge portion of the first electrode and exposing a central portion of the first electrode; an emitting layer and a second electrode sequentially disposed on the bank layer and the first electrode exposed through the bank layer; and a passivation layer on the second electrode and wrapping the emitting layer and the second electrode.

The passivation layer may extend to cover a top surface and a side surface of the emitting layer and the second electrode and contacts a sidewall of the trench.

The emitting layer may include a first stack on the first electrode, a charge generating layer on the first stack and a second stack on the charge generating layer.

The charge generating layer and the second electrode at the trench may be insulated from each other.

The display device may further comprise an oxidation portion having an insulation property disposed at an approaching portion of the charge generating layer and the second electrode and disposed over the trench.

A thickness of each of the first stack, the charge generating layer, the second stack and the second electrode at the trench may be smaller than a thickness of each of the first stack, the charge generating layer, the second stack and the second electrode at other portion except for the trench.

A width of the trench may be equal to or greater than 0.6 times of a thickness of the emitting layer.

A width of the trench may be equal to or smaller than 1.0µm.

The display device may further comprise: a thin film transistor between the substrate and the interlayer insulating layer in each of the first and second subpixels, and the thin film transistor connected to the first electrode; and first, second and third encapsulating layers sequentially disposed on the passivation layer.

In another aspect of the present disclosure, a method of fabricating an organic light emitting diode display device includes: forming an interlayer insulating layer on a substrate; forming a trench between first and second subpixels in the interlayer insulating layer; forming a first electrode in each of the first and second subpixels on the interlayer insulating layer; forming a bank layer covering an edge portion of the first electrode and exposing a central portion of the first electrode; sequentially forming an emitting layer and a second electrode on the bank layer and the first electrode exposed through the bank layer, the emitting layer and the second electrode divided into the first and second subpixels over the trench in the interlayer insulating layer; and forming a passivation layer on the second electrode, the passivation layer wrapping the emitting layer and the second electrode.

The passivation layer may be formed through an atomic layer deposition method.

The forming the emitting layer may comprise: forming a first stack on the first electrode; forming a charge generating layer on the first stack; and forming a second stack on the charge generating layer.

The charge generating layer and the second electrode at the trench may be insulated from each other.

An oxidation portion having an insulation property may be formed at an approaching portion of the charge generating layer and the second electrode over the trench.

A thickness of each of the first stack, the charge generating layer, the second stack and the second electrode at the trench may be smaller than a thickness of each of the first stack, the charge generating layer, the second stack and the second electrode at other portion except for the trench.

A width of the trench is equal to or greater than 0.6 times of a thickness of the emitting layer.

A width of the trench may be equal to or smaller than 1.0µm.

The method may further comprise: forming a thin film transistor between the substrate and the interlayer insulating layer in each of the first and second subpixels, the thin film transistor connected to the first electrode; and sequentially forming first, second and third encapsulating layers on the passivation layer.

It is to be understood that both the foregoing general description and the following detailed description are explanatory and are intended to provide further explanation of the disclosure.

### BRIEF DESCRIPTION OF THE DRAWINGS

The accompanying drawings, which are included to provide a further understanding of the disclosure and are incorporated in and constitute a part of this disclosure, illustrate aspects of the disclosure and together with the description serve to explain the principles of the disclosure.

In the drawings:
FIG. 1 is a view showing an organic light emitting diode display device according to an aspect of the present disclosure;
FIG. 2 is a cross-sectional view taken along line II-II of FIG. 1;
FIGs. 3A to 3F are cross-sectional views showing a method of fabricating an organic light emitting diode display device according to an aspect of the present disclosure;
FIG. 4A is a view showing an emission spectrum of an organic light emitting diode display device according to a comparison example; and
FIG. 4B is a view showing an emission spectrum of an organic light emitting diode display device according to an aspect of the present disclosure.

### DETAILED DESCRIPTION

Advantages and features of the present disclosure, and implementation methods thereof will be clarified through following example aspects described with reference to the accompanying drawings. The present disclosure may, however, be embodied in different forms and should not be construed as limited to the example aspects set forth herein. Rather, these example aspects are provided so that this disclosure may be sufficiently thorough and complete to assist those skilled in the art to fully understand the scope of the present disclosure.

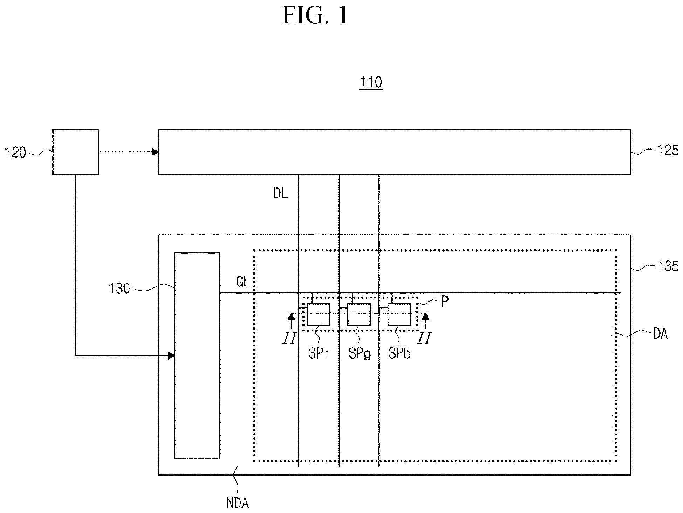

FIG. 1 is a view showing an organic light emitting diode display device according to an aspect of the present disclosure.

In FIG. 1, an organic light emitting diode (OLED) display device 110 according to an aspect of the present disclosure includes a timing controlling unit 120, a data driving unit 125, a gate driving unit 130 and a display panel 135.

The timing controlling unit 120 generates an image data, a data control signal and a gate control signal using an image signal and a plurality of timing signals including a data enable signal, a horizontal synchronization signal, a vertical synchronization signal and a clock signal transmitted from an external system such as a graphic card or a television system. Because a vertical period (or frame period) and a horizontal period may be known by counting the data enable signal, the vertical synchronization signal and the horizontal synchronization signal may be omitted. The data enable signal has a cycle of one horizontal period (1H). The timing controlling unit 120 transmits the image data and the data control signal to the data driving unit 125 and transmits the gate control signal to the gate driving unit 130.

The data driving unit 125 generates a data signal (data voltage) using the data control signal and the image data transmitted from the timing controlling unit 120 and supplies the data signal to a data line DL of the display panel 135.

The gate driving unit 130 generates a gate signal (gate voltage) using the gate control signal transmitted from the timing controlling unit 120 and supplies the gate signal to a gate line GL of the display panel 135. In addition, the gate driving unit 130 may generate an emission signal according to a structure of each subpixel SPr, SPg and SPb and may supply the emission signal to the display panel 135.

The gate driving unit 130 may have a gate in panel (GIP) type to be formed in a non-display area NDA of a substrate of the display panel 135 having the gate line GL, the data line DL and a pixel P. As an example, the gate driving unit 130 may be connected to the display panel 135 in a tape automated bonding (TAB) type, or connected to the display panel 135 in a chip on glass (COG) type or a chip on panel (COP) type, or connected to the display panel 135 in a chip on film (COF) type.

The display panel 135 includes a display area DA at a central portion thereof and a non-display area NDA in the vicinity of the display area DA or surrounding the display area DA. The display panel 135 displays an image using the gate signal and the data signal. For displaying an image, the display panel 135 includes a plurality of pixels P, a plurality of gate lines GL and a plurality of data lines DL in the display area DA.

Each of the plurality of pixels P may include red, green and blue subpixels SPr, SPg and SPb. As an example, the plurality of pixels P may also include a light emitting element of a subpixel of other colors. The gate line GL and the data line DL cross each other to define the red, green and blue subpixels SPr, SPg and SPb, and each of the red, green and blue subpixels SPr, SPg and SPb is connected to the gate line GL and the data line DL.

Although not shown, each of the red, green and blue subpixels SPr, SPg and SPb may include a plurality of thin film transistors such as a switching thin film transistor and a driving thin film transistor, a storage capacitor and a light emitting diode.

For example, each of the plurality of pixels P may include red, green, blue and white subpixels SPr, SPg, SPb and SPw. The gate line GL and the data line DL cross each other to define the red, green, blue and white subpixels SPr, SPg, SPb and SPw, and each of the red, green, blue and white subpixels SPr, SPg, SPb and SPw is connected to the gate line GL and the data line DL. In addition, each of the red, green, blue and white subpixels SPr, SPg, SPb and SPw may include a plurality of thin film transistors such as a switching thin film transistor and a driving thin film transistor, a storage capacitor and a light emitting diode.

A cross-sectional structure of the subpixel of the OLED display device 110 will be illustrated with reference to a drawing.

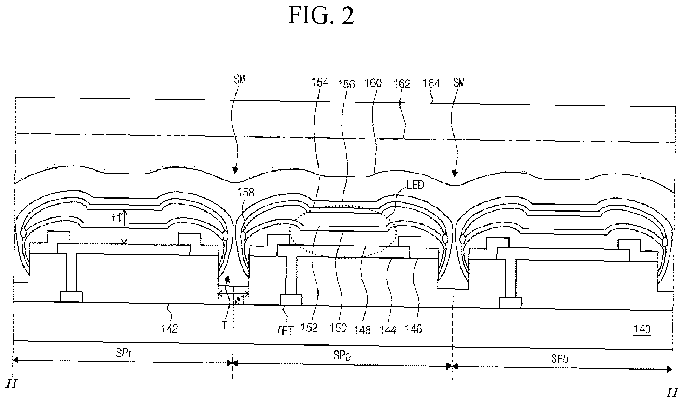

FIG. 2 is a cross-sectional view taken along a ling II-II of FIG. 1.

In FIG. 2, each of the red, green and blue subpixels SPr, SPg and SPb of the OLED display device 110 according to an aspect of the present disclosure includes a thin film transistor (TFT) and a light emitting diode LED.

The thin film transistor TFT is disposed in each of the red, green and blue subpixels SPr, Spg and SPb on a substrate 140.

The substrate 140 may include a glass, a plastic, a semiconductor material or a flexible polymer film. For example, the substrate 140 may be a wafer formed of a single crystalline silicon. For example, the flexible polymer film may be made of any one of polyimide (PI), polyethylene terephthalate (PET), acrylonitrile-butadiene-styrene copolymer(ABS), polymethyl methacrylate(PMMA), polyethylene naphthalate (PEN), polycarbonate (PC), polyethersulfone (PES), polyarylate (PAR), polysulfone (PSF), cyclic olefin copolymer(COC), triacetylcellulose(TAC), polyvinyl alcohol(PVA) and polystyrene(PS).

When the OLED display device 110 has a top emission type where a light is emitted toward an upper portion, the substrate 140 may include a transparent material or an opaque material. When the OLED display device 110 has a bottom emission type where a light emitted from the pixel array may be irradiated onto a rearward region behind the substrate 140 to allow an image to be displayed, or a dual emission type, the substrate 140 may include a transparent material. For example, the transparent material may include Polyethylene terephthalate (PET), Polyethylene naphthalate (PEN), Poly(methyl methacrylate) (PMMA), Cyclo-olefin polymers (COP), cyclo-olefin copolymers (COC) and the like.

The thin film transistor TFT may be a driving thin film transistor. Although not shown, a switching thin film transistor, a sensing thin film transistor and a storage capacitor connected to the driving thin film transistor, the gate line GL (of FIG. 1) and the data line DL (of FIG. 1) connected to the switching thin film transistor, a power line connected to the driving thin film transistor, and a sensing line and a reference line connected to the sensing thin film transistor may be disposed on the substrate 140.

According to the embodiment of the present disclosure, a driving TFT may be manufactured using an oxide semiconductor material, and at least one switching TFT may be also manufactured using the oxide semiconductor material.

The oxide semiconductors may be made of a metal oxide such as zinc (Zn), indium (In), gallium (Ga), tin (Sn), and titanium (Ti) or a combination of a metal such as zinc (Zn), indium (In), gallium (Ga), tin (Sn), or titanium (Ti) and its oxide. Specifically, the oxide semiconductor may include zinc oxide (ZnO), zinc-tin oxide (ZTO), zinc-indium oxide (ZIO), indium oxide (InO), titanium oxide (TiO), indium-gallium-zinc oxide (IGZO), indium-zinc-tin oxide (IZTO), indium zinc oxide (IZO), indium gallium tin oxide (IGTO), and indium gallium oxide (IGO).

Alternatively, the various TFTs of the present disclosure may also be manufactured using a polycrystalline semiconductor material.

The switching thin film transistor may be switched according to the gate signal of the gate line GL to transmit the data signal of the data line DL to the driving thin film transistor.

The driving thin film transistor may be switched according to the data signal transmitted through the switching thin film transistor to transmit a current according to a high level voltage of the power line to the light emitting diode LED.

The sensing thin film transistor may be switched according to a sensing signal of the sensing line to transmit a reference voltage to the driving thin film transistor or to detect a voltage of the driving thin film transistor.

The storage capacitor may maintain the data signal transmitted through the switching thin film transistor for one frame.

An interlayer insulating layer 142 is disposed on the thin film transistor TFT, and the first electrode 144 is disposed in each of the red, green and blue subpixels SPr, SPg and SPb on the interlayer insulating layer 142.

For example, the interlayer insulating layer 142 may include an inorganic insulating material such as silicon oxide (SiOx) and silicon nitride (SiNx) or an organic insulating material such as acrylic resin, epoxy resin, phenolic resin, polyamide resin and polyimide resin and may have a single layer or a multiple layer.

The first electrode 144 is connected to the thin film transistor TFT through a contact hole in the interlayer insulating layer 142.

For example, the first electrode 144 may include a transparent conductive material, a half transmissive metallic material or a metallic material having a relatively high reflectance.

When the OLED display device 110 has a top emission type, the first electrode 144 may have a relatively high reflectance. For example, the first electrode 144 may include have a triple layer (Ti/Al/Ti) of titanium (Ti), aluminum (Al) and titanium (Ti), a triple layer (ITO/Al/ITO) of indium tin oxide (ITO), aluminum (Al) and indium tin oxide (ITO) or a triple layer (ITO/Ag alloy/ITO) of indium tin oxide (ITO), silver (Ag) alloy and indium tin oxide (ITO). The silver (Ag) alloy may include an alloy of silver palladium copper (Ag-Pd-Cu: APC).

When the OLED display device 110 has a bottom emission type, the first electrode 144 may have a transparency. For example, the first electrode 144 may include a transparent conductive oxide (TCO) such as indium tin oxide (ITO) and indium zinc oxide (IZO) or a semi-transmissive conductive material such as magnesium (Mg), silver (Ag) and an alloy of magnesium silver (MgAg).

The first electrode 144 may be an anode of a light emitting diode LED.

A bank layer 146 is disposed on the first electrode 144, and a trench T is formed in the bank layer 146 and the interlayer insulating layer 142 at a border portion between the red, green and blue subpixels SPr, SPg and SPb.

The bank layer 146 may be a pixel-defining film or a pixel-defining layer, which defines an emission region of each subpixel, exposing the first electrode 144 of each sub-pixel. The bank layer 146 may be made of an opaque material (e.g., black material) to prevent optical interference between adjacent sub-pixels. In this case, the bank layer 146 may include a light blocking material made of at least one of color pigment, organic black, black ink and carbon.

The bank layer 146 covers an edge portion of the first electrode 144 and has an opening exposing a central portion of the first electrode 144. The central portion of the first electrode 144 exposed through the opening of the bank layer 146 may be defined as an emission area, and the other portion except for the emission area may be defined as a non-emission area.

Although the bank layer 146 is disposed to expose the trench T in an aspect of FIG. 2, the bank layer 146 may be consecutively disposed between the adjacent subpixels to cover the trench T.

For example, the bank layer 146 may include an inorganic insulating material such as silicon oxide (SiOx) and silicon nitride (SiNx) or an organic insulating material such as acrylic resin, epoxy resin, phenolic resin, polyamide resin and polyimide resin and may have a single layer or a multiple layer.

The trench T may divide first and second stacks 148 and 152, a charge generating layer 150 and a second electrode 154 into the adjacent subpixels in a subsequent process to reduce or minimize a lateral leakage current.

When the trench T is not formed in the bank layer 146 and the interlayer insulating layer 142, the first and second stacks 148 and 152, the charge generating layer 150 and the second electrode 154 may be consecutively disposed between the adjacent subpixels to cause a lateral leakage current. As a result, the undesired subpixel may emit a light and a color reproducibility may be reduced.

The reduction of the color reproducibility in a case when a lateral leakage current occurs between the subpixels emitting a light of the same color may be greater than the reduction of the color reproducibility in a case when a lateral leakage current occurs between the subpixels emitting a light of the different color.

In the OLED display device 110 according to an aspect of the present disclosure, to reduce or minimize a lateral leakage current between the red, green and blue subpixels SPr, SPg and SPb emitting a light of the different color, the trench T may be disposed between the red, green and blue subpixels SPr, SPg and SPb emitting a light of the different color.

The trench T may not be disposed between the subpixels emitting a light of the same color.

For example, when the OLED display device 110 has a stripe type, the red, green and blue subpixels SPr, SPg and SPb may be sequentially and repeatedly disposed along a horizontal direction parallel to the gate line GL (of FIG. 1), and the subpixels corresponding to the same color among the red, green and blue subpixels SPr, SPg and SPb may be disposed along a vertical direction parallel to the data line DL (of FIG. 1). The trench T may be disposed as a line shape along the vertical direction between the red, green and blue subpixels SPr, SPg and SPb emitting a light of different color and may not be disposed along the horizontal direction between the subpixels emitting a light of the same color.

A first stack 148, a charge generating layer (CGL) 150, a second stack 152 and a second electrode 154 are sequentially disposed on the bank layer 146 and the first electrode 144 exposed through the opening of the bank layer 146. The first stack 148, the charge generating layer 150 and the second stack 152 constitute an emitting layer, and the first electrode 144, the first stack 148, the charge generating layer 150, the second stack 152 and the second electrode 154 constitute a light emitting diode LED.

The first stack 148 may include a hole injecting layer (HIL), a hole transporting layer (HTL), an emitting material layer (EML) and an electron transporting layer (ETL), and the emitting material layer of the first stack 148 may emit one of a red colored light, a green colored light, a blue colored light and a yellow colored light.

The charge generating layer 150 may include a negative type charge generating layer for supplying an electron to the first stack 148 and a positive type charge generating layer for supplying a hole to the second stack 152.

The second stack 152 may include a hole transporting layer, an emitting material layer, an electron transporting layer and an electron injecting layer, and the emitting material layer of the second stack 152 may emit one of a red colored light, a green colored light, a blue colored light and a yellow colored light.

The emitting material layer of the second stack 152 may emit a light of a color different from a color of a light emitted from the emitting material layer of the first stack 148. For example, the emitting material layer of the first stack 148 may emit a blue colored light and the emitting material layer of the second stack 152 may emit a yellow colored light. Alternatively, the emitting material layer of the first stack 148 may emit a blue colored light and the emitting material layer of the second stack 152 may emit a red colored light and a green colored light.

The second electrode 154 may include a transparent conductive material, a half transmissive metallic material or metallic material having a relatively high reflectance.

When the OLED display device 110 has a top emission type or a dual emission type, the second electrode 154 may have a transparency. For example, the second electrode 154 may include a transparent conductive oxide (TCO) such as indium tin oxide (ITO) and indium zinc oxide (IZO) or a semi-transmissive conductive material such as magnesium (Mg), silver (Ag) and an alloy of magnesium silver (MgAg).

When the OLED display device 110 has a bottom emission type, the second electrode 154 may have a relatively high reflectance. For example, the second electrode 154 may include a triple layer (Ti/Al/Ti) of titanium (Ti), aluminum (Al) and titanium (Ti), a triple layer (ITO/Al/ITO) of indium tin oxide (ITO), aluminum (Al) and indium tin oxide (ITO) or a triple layer (ITO/Ag alloy/ITO) of indium tin oxide (ITO), silver (Ag) alloy and indium tin oxide (ITO). The silver (Ag) alloy may include an alloy of silver palladium copper (Ag-Pd-Cu: APC).

The second electrode 154 may be a cathode of a light emitting diode LED.

Each of the first stack 148, the charge generating layer 150, the second stack 152 and the second electrode 154 is divided into the red, green and blue subpixels SPr, SPg and SPb and does not contact over the trench T due to a step difference of the trench T. Each of the first stack 148, the charge generating layer 150, the second stack 152 and the second electrode 154 is disposed on a sidewall of the trench T with a relatively small thickness.

For example, a thickness of each of the first stack 148, the charge generating layer 150, the second stack 152 and the second electrode 154 may be reduced from the sidewall of the trench T to the substrate 140 to be cut.

In the OLED display device 110 according to an aspect of the present disclosure, the first stack 148, the charge generating layer 150, the second stack 152 and the second electrode 154 between the adjacent two of the red, green and blue subpixels SPr, SPg and SPb are divided over the trench T to be separated from each other. As a result, a lateral leakage current between the adjacent two of the red, green and blue subpixels SPr, SPg and SPb emitting a light of the different color may be reduced or minimized.

To divide the second stack 152 and the second electrode 154 as well as the first stack 148 and the charge generating layer 150, the trench may be formed to have a relatively great width. The width of the trench T may be determined based on a thickness of the emitting layer of the first stack 148, the charge generating layer 150 and the second stack 152.

For example, a first width w1 of the trench T may be determined equal to or greater than 0.6 times of a first thickness t1 of the emitting layer of the first stack 148, the charge generating layer 150 and the second stack 152 (w1 ≥ 0.6^{∗}t1). Also, a first width w1 of the trench T may be determined equal to or greater than 0.8 times of a first thickness t1 of the emitting layer including the first stack 148, the charge generating layer 150 and the second stack 152 (w1≥0.8^{∗}t1). When the first width w1 of the trench T is smaller than 0.6 times of the first thickness t1 of the emitting layer of the first stack 148, the charge generating layer 150 and the second stack 152, the first stack 148, the charge generating layer 150 and the second stack 152 of the emitting layer between the adjacent two of the red, green and blue subpixels SPr, SPg and SPb may not be divided over the trench T to be connected over the trench T.

When the trench T has a relatively great width, the emission area is reduced and an aperture ratio is reduced.

For example, the first width w1 of the trench T may be equal to or smaller than about 1.0 µm (w1 ≤ 1.0 µm). Preferably, the first width w1 of the trench T may be greater than or equal to about 0.2µm and smaller than or equal to about 0.8µm (0.2µm≤w1≤0.8µm). When the first width w1 of the trench T is greater than about 1.0µm, the emission area and the aperture ratio may be excessively reduced and a luminance may be reduced.

The charge generating layer 150 and the second electrode 154 may be disposed on the sidewall of the trench T to contact each other. When the charge generating layer 150 and the second electrode 154 contact each other, the charge generating layer 150 and the second electrode 154 may be electrically shorted. As a result, a voltage may not be applied to the second stack 152 and the second stack 152 may not emit a light.

In the OLED display device 110 according to an aspect of the present disclosure, to prevent contact of the charge generating layer 150 and the second electrode 154, an oxidation portion 158 having an insulation property is formed in an approaching portion of the charge generating layer 150 and the second electrode 154 over the trench T. As a result, an electrical shortage between the charge generating layer 150 and the second electrode 154 is prevented.

A passivation layer 156 is disposed on the second electrode 154. The passivation layer 156 may be disposed on a top surface and at least upper portion of a side surface of the first stack 148, the charge generating layer 150, the second stack 152 and the second electrode 154. The passivation layer 156 may completely or partly wrap the first stack 148, the charge generating layer 150, the second stack 152 and the second electrode 154 such that the top surface and the side surface of the first stack 148, the charge generating layer 150, the second stack 152 and the second electrode 154 are not exposed.

For example, the passivation layer 156 may extend to cover the top surface and the side surface of the first stack 148, the charge generating layer 150, the second stack 152 and the second electrode 154 and may contact the sidewall of the trench T.

The passivation layer 156 may be formed through a deposition method having an excellent step coverage.

For example, the passivation layer 156 may be formed through an atomic layer deposition (ALD) method and may have a single layer or a multiple layer including an inorganic insulating material such as aluminum oxide (AlOx), silicon oxide (SiOx), silicon nitride (SiNx) and silicon oxynitride (SiOxNy).

In the OLED display device 110 according to an aspect of the present disclosure, since the passivation layer 156 completely wraps the first stack 148, the charge generating layer 150, the second stack 152 and the second electrode 154, penetration of a moisture and an oxygen of an exterior into the first and second stacks 148 and 152 may be minimized.

First, second and third encapsulating layers 160, 162 and 164 are sequentially disposed on the passivation layer 156.

The first and third encapsulating layers 160 and 164 may include an inorganic insulating material such as silicon oxide (SiOx) and silicon nitride (SiNx), and the second encapsulating layer 162 may include an organic insulating material such as acrylic resin, epoxy resin, phenolic resin, polyamides resin, unsaturated polyesters resin, polyphenylene resin, polyphenylene sulfides resin and benzocyclobutene.

The first, second and third encapsulating layers 160, 162 and 164 may block a moisture and an oxygen of an exterior.

The first encapsulating layer 160 may be disposed along a shape of the step difference of the passivation layer 156. Since the passivation layer 156 is divided between the adjacent two of the red, green and blue subpixels SPr, SPg and SPb over the trench T, the first encapsulating layer 160 may have a step corresponding line SM corresponding to the trench T.

Since a property of blocking a moisture and an oxygen of the first encapsulating layer 160 is deteriorated at the step corresponding line SM, a moisture and an oxygen of an exterior may penetrate through the step corresponding line SM of the first encapsulating layer 160.

In the OLED display device 110 according to an aspect of the present disclosure, since the passivation layer 156 completely wraps the first stack 148, the charge generating layer 150, the second stack 152 and the second electrode 154, a moisture and an oxygen of an exterior penetrating through the step corresponding line SM may be blocked by the passivation layer 156 and penetration of a moisture and an oxygen of an exterior into the first and second stacks 148 and 152 may be minimized.

Although not shown, red, green and blue color filters may be disposed on the third encapsulating layer 164 in the red, green and blue subpixels SPr, SPg and SPb, respectively.

In the OLED display device 110 according to an aspect of the present disclosure, since the trench T having a relatively great width is disposed between the adjacent two of the red, green and blue subpixels SPr, SPg and SPb, the second stack 152 and the second electrode 154 as well as the first stack 148 and the charge generating layer 150 are divided over the trench T. As a result, a lateral leakage current is minimized.

Further, since the passivation layer 156 wrapping the first stack 148, the charge generating layer 150, the second stack 152 and the second electrode 154 is disposed on the second electrode 154, penetration of a moisture and an oxygen of an exterior through the step corresponding line SM into the first and second stacks 148 and 152 is minimized and a reliability is improved.

In addition, since the passivation layer 156 wrapping the first stack 148, the charge generating layer 150, the second stack 152 and the second electrode 154 blocks a moisture and an oxygen of an exterior, thicknesses of the first, second and third encapsulating layers 160, 162 and 164 are reduced and a fabrication cost is reduced.

Although the emitting layer has a 2-stack structure of the first stack 148, the charge generating layer 150 and the second stack 152 in an aspect of FIG. 2, the emitting layer may have a multiple-stack structure of three or more stacks and two or more charge generating layers in another aspect. In another aspect, the three or more stacks, the two or more charge generating layers and the second electrode may be divided due to the trench, and the passivation layer may be disposed to wrap the three or more stacks, the two or more charge generating layers and the second electrode.

Although an encapsulating portion including the first, second and third encapsulating layers 160, 162 and 164 is shown in an exemplary embodiment of FIG. 2, number of encapsulating layers is not limited thereto, for example, the encapsulating portion may include n encapsulating layers, where n is an integer. For example, the encapsulation portion may include n encapsulating layers alternately stacked between inorganic encapsulation layer and organic encapsulation layer.

A method of fabricating the OLED display device 110 will be illustrated with reference to drawings.

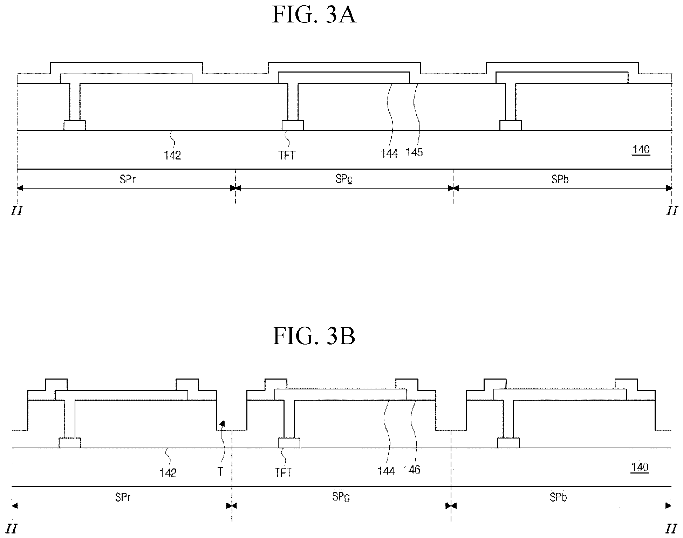

FIGs. 3A to 3F are cross-sectional views showing a method of fabricating an organic light emitting diode display device according to an aspect of the present disclosure.

In FIG. 3A, the thin film transistor TFT is formed in each of the red, green and blue subpixels SPr, SPg and SPb on the substrate 140, and the interlayer insulating layer 142 is formed on the thin film transistor TFT over the entire substrate 140.

Next, the contact hole exposing the thin film transistor TFT is formed in the interlayer insulating layer 142, and the first electrode 144 is formed in each of the red, green and blue subpixels SPr, SPg and SPb.

The first electrode 144 is connected to the thin film transistor TFT through the contact hole in the interlayer insulating layer 142.

Next, a bank material layer 145 is formed on the first electrode 144 over the entire substrate 140.

In FIG. 3B, the bank layer 146 covering the edge portion of the first electrode 144 and having the opening exposing the central portion of the first electrode 144 is formed by etching the bank material layer 145 and the interlayer insulating layer 142, and the trench T is formed in the interlayer insulating layer 142 between the adjacent two of the red, green and blue subpixels SPr, SPg and SPb.

Although the trench T is formed after the first electrode 144 is formed in an aspect of FIG. 3B, the first electrode 144 may be formed after the trench T is formed in the interlayer insulating layer 142 in another aspect.

For example, after the interlayer insulating layer 142 is formed, the trench T may be formed with the contact hole exposing the thin film transistor TFT.

Although the trench T is formed after the bank material layer 145 is formed in an aspect of FIG. 3B, the bank material layer 145 may be formed after the trench T is formed in the interlayer insulating layer 142 in another aspect.

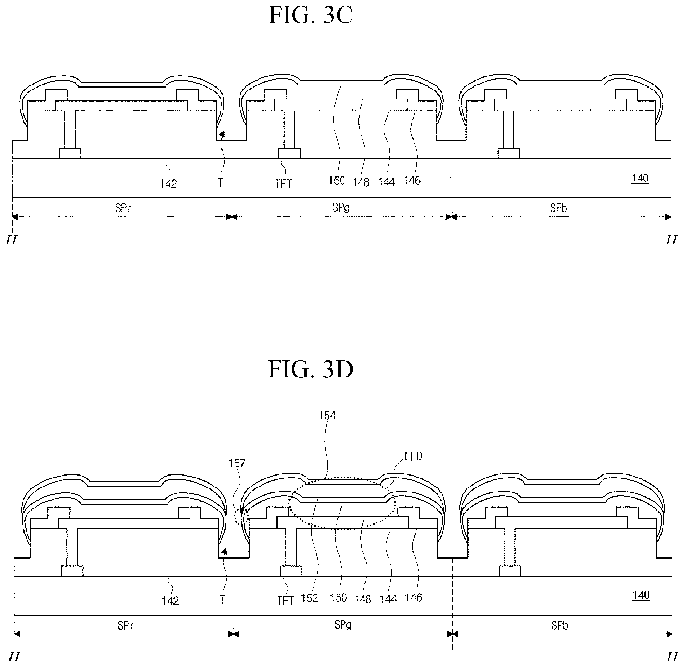

In FIG. 3C, the first stack 148 and the charge generating layer 150 are sequentially formed on the bank layer 146 and the first electrode 144 exposed through the opening of the bank layer 146.

The first stack 148 and the charge generating layer 150 may be formed through a deposition process such as a thermal evaporation or a soluble process such as an inkjet printing and a coating.

Each of the first stack 148 and the charge generating layer 150 is divided into the red, green and blue subpixels SPr, SPg and SPb and is not consecutively formed over the trench T due to a step difference of the trench T. Each of the first stack 148 and the charge generating layer 150 is disposed on a sidewall of the trench T with a relatively small thickness. For example, a thickness of each of the first stack 148 and the charge generating layer 150 at the trench T is smaller than a thickness of each of the first stack 148 and the charge generating layer 150 at other portion except for the trench T. In other words, a thickness of the first stack 148 at the trench T may be smaller than a thickness of the first stack 148 at other portion except for the trench T, and a thickness of the charge generating layer 150 at the trench T may be smaller than a thickness of the charge generating layer 150 at other portion except for the trench T.

For example, a thickness of each of the first stack 148 and the charge generating layer 150 may be reduced from the sidewall of the trench T to the substrate 140 to be cut.

In FIG. 3D, the second stack 152 and the second electrode 154 are sequentially formed on the charge generating layer 150.

The second stack 152 may be formed through a deposition process such as a thermal evaporation or a soluble process such as an inkjet printing and a coating, and the second electrode 154 may be formed through a deposition process such as a thermal evaporation.

Each of the second stack 152 and the second electrode 154 is divided into the red, green and blue subpixels SPr, SPg and SPb and is not consecutively formed over the trench T due to a step difference of the trench T. Each of the second stack 152 and the second electrode 154 is disposed on a sidewall of the trench T with a relatively small thickness.

For example, a thickness of each of the second stack 152 and the second electrode 154 may be reduced from the sidewall of the trench T to the substrate 140 to be cut.

The first electrode 144, the first stack 148, the charge generating layer 150, the second stack 152 and the second electrode 154 constitute the light emitting diode LED.

The charge generating layer 150 and the second electrode 154 contact each other on the sidewall of the trench T to constitute the approaching portion 157. Since the charge generating layer 150 and the second electrode 154 are electrically shorted, a voltage may not be applied to the second stack 152 and the second stack 152 may not emit a light.

To prevent the electrical shortage between the charge generating layer 150 and the second electrode 154, the approaching portion 157 between the charge generating layer 150 and the second electrode 154 over the trench T is oxidized through a subsequent process of forming the passivation layer 156 to become the oxidation portion 158. As a result, an electrical shortage between the charge generating layer 150 and the second electrode 154 is prevented.

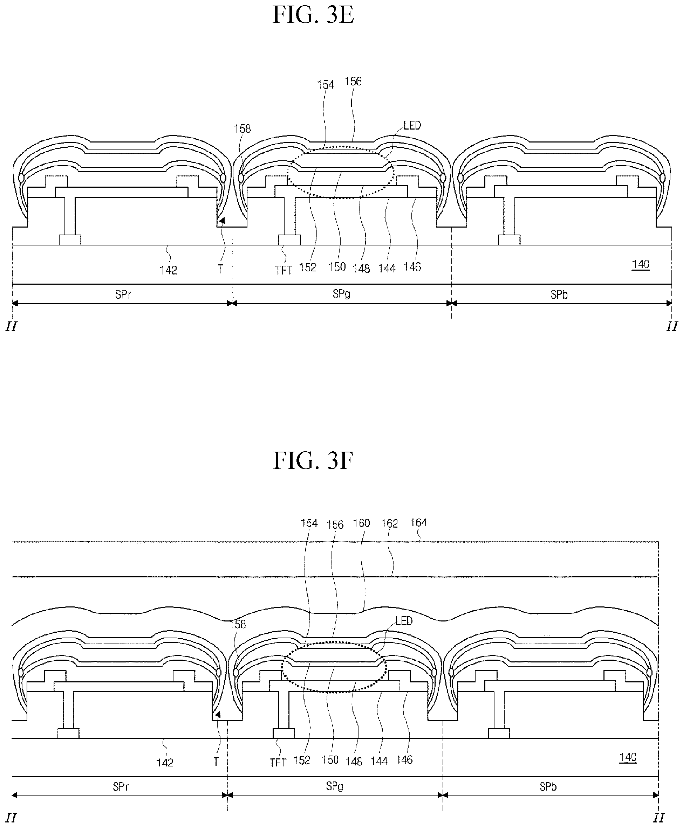

In FIG. 3E, the passivation layer 156 is formed on the second electrode 154.

The passivation layer 156 is formed on the top surface and the at least upper portion of the side surface of the first stack 148, the charge generating layer 150, the second stack 152 and the second electrode 154. The passivation layer 156 may completely wrap the first stack 148, the charge generating layer 150, the second stack 152 and the second electrode 154 such that the top surface and the side surface of the first stack 148, the charge generating layer 150, the second stack 152 and the second electrode 154 are not exposed.

The passivation layer 156 may be formed through a deposition method having an excellent step coverage.

For example, the passivation layer 156 may be formed through an atomic layer deposition (ALD) method and may include an inorganic insulating material such as aluminum oxide (AlOx), silicon oxide (SiOx) and silicon nitride (SiNx).

In FIG. 3F, the first, second and third encapsulating layers 160, 162 and 164 are sequentially formed on the passivation layer 156.

The first and third encapsulating layers 160 and 164 may include an inorganic insulating material such as silicon oxide (SiOx) and silicon nitride (SiNx), and the second encapsulating layer 162 may include an organic insulating material such as acrylic resin and epoxy resin.

The first and third encapsulating layers 160 and 164 may be formed through a chemical vapor deposition (CVD) method or an atomic layer deposition (ALD) method, and the second encapsulating layer 162 may be formed through a vapor deposition method, a printing method, a slit coating method or an inkjet method.

In the OLED display device 110 according to an aspect of the present disclosure, the electrical shortage between the charge generating layer 150 and the second electrode 154 may be prevented by changing the approaching portion 157 to the oxidation portion 158.

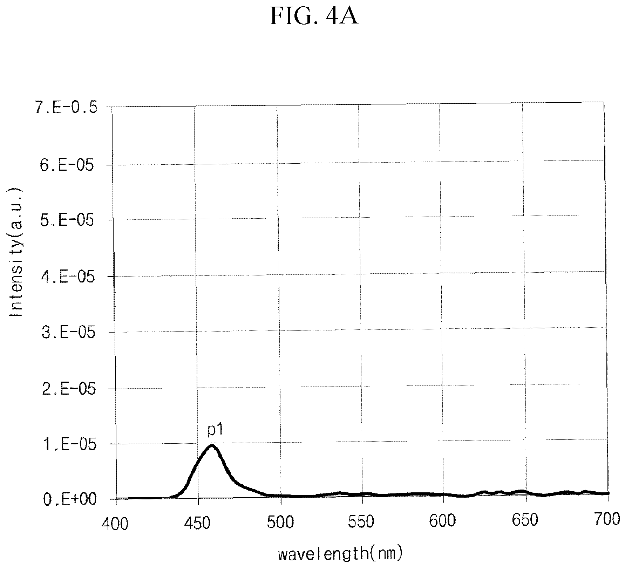

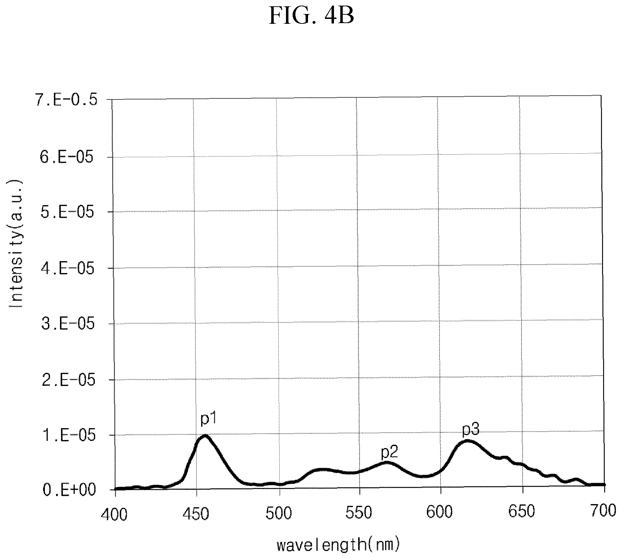

FIG. 4A is a view showing an emission spectrum of an organic light emitting diode display device according to a comparison example, and FIG. 4B is a view showing an emission spectrum of an organic light emitting diode display device according to an aspect of the present disclosure.

In FIG. 4A, after the charge generating layer 150 and the second electrode 154 contact each other to form the approaching portion 157, a process of changing the approaching portion 157 to the oxidation portion 158 is not performed in an organic light emitting diode (OLED) display device according to a comparison example. Since a voltage is not applied to the second stack 152 due to the electrical shortage between the charge generating layer 150 and the second electrode 154, the second stack 152 does not emit a light and only the first stack 148 emits a light. As a result, the emission spectrum of the OLED display device according to a comparison example has only a first peak p1 corresponding to a blue colored light emitted from the first stack 148.

In FIG. 4B, after the charge generating layer 150 and the second electrode 154 contact each other to form the approaching portion 157, the approaching portion 157 is changed to the oxidation portion 158 having an insulation property through a process of forming the passivation layer 156 in an organic light emitting diode (OLED) display device 110 according to an aspect of the present disclosure. As a result, the charge generating layer 150 and the second electrode 154 are not electrically shorted and a voltage is applied to the second stack 152.

Accordingly, the second stack 152 as well as the first stack 148 emits a light, and the emission spectrum of the OLED display device 110 according to an aspect of the present disclosure has a first peak p1 corresponding to a blue colored light emitted from the first stack 148 and second and third peaks p2 and p3 corresponding to green and red colored lights emitted from the second stack 152. Therefore, the light emitting diode LED of the first and second stacks 148 and 152 may emit a white colored light.

In the OLED display device 110 according to an aspect of the present disclosure, since the trench T having a relatively great width is disposed between the adjacent two of the red, green and blue subpixels SPr, SPg and SPb, the second stack 152 and the second electrode 154 as well as the first stack 148 and the charge generating layer 150 are divided over the trench T. As a result, a lateral leakage current is reduced or minimized.

Further, since the passivation layer 156 completely wrapping the first stack 148, the charge generating layer 150, the second stack 152 and the second electrode 154 is disposed on the second electrode 154, penetration of a moisture and an oxygen of an exterior through the step corresponding line SM into the first and second stacks 148 and 152 is reduced or minimized and a reliability is improved.

In addition, since the passivation layer 156 wrapping the first stack 148, the charge generating layer 150, the second stack 152 and the second electrode 154 blocks a moisture and an oxygen of an exterior, thicknesses of the first, second and third encapsulating layers 160, 162 and 164 are reduced and a fabrication cost is reduced.

Moreover, since the approaching portion 157 of the charge generating layer 150 and the second electrode 154 is changed to the oxidation portion 158 having an insulation property through a process of forming the passivation layer 156, the electric shortage between the charge generating layer 150 and the second electrode 154 is prevented and the light emitting diode LED of the first and second stacks 148 and 152 normally operates.

It will be apparent to those skilled in the art that various modifications and variations can be made in the organic light emitting diode display device and the method of fabricating the same of the present disclosure without departing from the scope of the present disclosure. Thus, it is intended that the present disclosure covers the modifications and variations of the aspects provided they come within the scope of the appended claims.

## Claims

1. An organic light emitting diode display device (100), comprising:
a substrate (140) having first and second subpixels;
an interlayer insulating layer (142) on the substrate (140) and having a trench (T) between the first and second subpixels;
a first electrode (144) disposed on the interlayer insulating layer (142) in each of the first and second subpixels;
a bank layer (146) covering an edge portion of the first electrode (144) and exposing a central portion of the first electrode (144);
an emitting layer (148, 150, 152) and a second electrode (154) sequentially disposed on the bank layer (146) and the first electrode (144) exposed through the bank layer (146); and
a passivation layer (156) disposed on the second electrode (154) and wrapping the emitting layer (148, 150, 152) and the second electrode (154).

2. The display device (100) of claim 1, wherein the passivation layer (156) extends to cover a top surface and a side surface of the emitting layer (148, 150, 152) and the second electrode (154) and contacts a sidewall of the trench (T).

3. The display device (100) of claim 1 or 2, wherein the emitting layer (148, 150, 152) includes a first stack (148) on the first electrode (144), a charge generating layer (150) on the first stack (148) and a second stack (152) on the charge generating layer (150).

4. The display device (100) of claim 3, wherein the charge generating layer (150) and the second electrode (154) at the trench (T) are insulated from each other.

5. The display device (100) of claim 3 or 4, further comprising an oxidation portion (158) having an insulation property disposed at an approaching portion of the charge generating layer (150) and the second electrode (154) and disposed over the trench (T).

6. The display device (100) of any of claims 3 to 5, wherein a thickness of each of the first stack (148), the charge generating layer (150), the second stack (152) and the second electrode (154) at the trench (T) is smaller than a thickness of each of the first stack (148), the charge generating layer (150), the second stack (152) and the second electrode (154) at other portion except for the trench (T).

7. The display device (100) of any of claims 1 to 6, wherein a width of the trench (T) is equal to or greater than 0.6 times of a thickness of the emitting layer (148, 150, 152), and/or wherein a width of the trench (T) is equal to or smaller than 1.0µm.

8. The display device (100) of any of claims 1 to 7, further comprising:
a thin film transistor (TFT) between the substrate (140) and the interlayer insulating layer (142) in each of the first and second subpixels, and the thin film transistor (TFT) connected to the first electrode (144); and
first, second and third encapsulating layers (160, 162, 164) sequentially disposed on the passivation layer (156).

9. A method of fabricating an organic light emitting diode display device (100), comprising:
forming an interlayer insulating layer (142) on a substrate (140);
forming a trench (T) between first and second subpixels in the interlayer insulating layer (142);
forming a first electrode (144) in each of the first and second subpixels on the interlayer insulating layer (142);
forming a bank layer (146) covering an edge portion of the first electrode (144) and exposing a central portion of the first electrode (144);
sequentially forming an emitting layer (148, 150, 152) and a second electrode (154) on the bank layer (146) and the first electrode (144) exposed through the bank layer (146), the emitting layer (148, 150, 152) and the second electrode (154) divided into the first and second subpixels over the trench (T) in the interlayer insulating layer (142); and
forming a passivation layer (156) on the second electrode (154), the passivation layer (156) wrapping the emitting layer (148, 150, 152) and the second electrode (154).

10. The method of claim 9, wherein the passivation layer (156) is formed through an atomic layer deposition method.

11. The method of claim 9 or 10, wherein the forming the emitting layer (148, 150, 152) comprises:
forming a first stack (148) on the first electrode (144);
forming a charge generating layer (150) on the first stack (148); and
forming a second stack (152) on the charge generating layer (150).

12. The method of claim 11, wherein the charge generating layer (150) and the second electrode (154) at the trench (T) are insulated from each other, and/or wherein an oxidation portion (158) having an insulation property is formed at an approaching portion of the charge generating layer (150) and the second electrode (154) over the trench (T).

13. The method of claims 11 or 12, wherein a thickness of each of the first stack (148), the charge generating layer (150), the second stack (152) and the second electrode (154) at the trench (T) is smaller than a thickness of each of the first stack (148), the charge generating layer (150), the second stack (152) and the second electrode (154) at other portion except for the trench (T).

14. The method of any of claims 9 to 13, wherein a width of the trench (T) is equal to or greater than 0.6 times of a thickness of the emitting layer (148, 150, 152), and/or wherein a width of the trench (T) is equal to or smaller than 1.0µm.

15. The method of any of claims 9 to 14, further comprising:
forming a thin film transistor (TFT) between the substrate (140) and the interlayer insulating layer (142) in each of the first and second subpixels, the thin film transistor (TFT) connected to the first electrode (144); and
sequentially forming first, second and third encapsulating layers (160, 162, 164) on the passivation layer (156).
